# EUROPEAN PATENT APPLICATION

(11) **EP 4 318 556 A1**
(43) Date of publication of application: **07.02.2024**
(21) Application number: 22779492.2
(22) Date of filing: 02.02.2022
(51) Int. Cl.: H01L 21/66, G01N 21/64, G01N 21/88

(54) **INSPECTION METHOD, CONDUCTIVE MEMBER, AND INSPECTION DEVICE**

(30) Priority: 01.04.2021 JP 2021062950
(71) Applicant: Hamamatsu Photonics K.K., Hamamatsu-shi, Shizuoka 435-8558 (JP)
(72) Inventor: NAKAMURA, Tomonori, Hamamatsu-shi, Shizuoka 435-8558 (JP)
(74) Representative: Hoffmann Eitle
(86) International application number: PCT/JP2022/004057
(87) International publication number: WO 2022/209263

(57) **Abstract**

An inspection method includes: a contact step of bringing a conductive tape into contact with a sample provided with a plurality of light emitting elements; and a first measurement step of irradiating the sample with light and measuring light emission generated in the sample in a state in which the conductive tape contacts the sample after the contact step.

## Description

### Technical Field

An aspect of the present invention relates to an inspection method, a conductive member, and an inspection device.

### Background Art

As a method of determining whether a light emitting element group formed on a wafer is defective or not, a method of observing photoluminescence emitted from a light emitting element and determining whether the light emitting element is defective or not based on the luminance of the photoluminescence is known (for example, see Patent Literature 1). According to such a method, it is possible to efficiently inspect a large number of fine light emitting elements compared to, for example, a method of determining whether the light emitting element is defective or not by probing (that is, based on electrical characteristics).

### Citation List

### Patent Literature

[Patent Literature 1] Japanese Unexamined Patent Publication No. 2014-163857

### Summary of Invention

### Technical Problem

Here, in the method of observing photoluminescence as described above, a leak failure can be detected, but a contact failure (open failure, high resistance failure, and high threshold failure) cannot be detected appropriately. Therefore, in the method of observing photoluminescence as described above, a defective product (the light emitting element with a contact failure) may be included in the light emitting elements that are determined to be non-defective due to no leak failure. As a result, it may not be possible to appropriately determine whether the light emitting element is defective or not.

An aspect of the present invention has been made in view of the above-described circumstances and an object thereof is to improve the accuracy of determination on whether a light emitting element is defective or not by appropriately detecting a contact failure of the light emitting element in a method of determining whether the light emitting element is defective or not by observing photoluminescence.

### Solution to Problem

An inspection method according to an aspect of the present invention includes: a contact step of bringing a conductive member into contact with a measurement object provided with a plurality of light emitting elements; and a first measurement step of irradiating the measurement object with light and measuring light emission generated in the measurement object in a state in which the conductive member contacts the measurement object after the contact step.

According to the inspection method of an aspect of the present invention, the measurement object is irradiated with light and the light emission from the measurement object is measured in a state in which the conductive member contacts the measurement object provided with the plurality of light emitting elements. Here, since a state in which the conductive member contacts the measurement object is a state in which each light emitting element is in a short-circuited state, recombination of carriers is less likely to occur in the non-defective light emitting element and the light emission luminance is low. On the other hand, since recombination of carriers actively occurs in the light emitting element with a contact failure even in a state in which the conductive member contacts the measurement object (in a short-circuited state of each light emitting element), the light emission luminance is higher than that of the non-defective light emitting element. In this way, the light emission luminance from the measurement object in a state in which the conductive member contacts the measurement object varies depending on the presence or absence of the contact failure. Therefore, as in the inspection method according to an aspect of the present invention, since the measurement object is irradiated with light and the light emission from the measurement object is measured in a state in which the conductive member contacts the measurement object, it is possible to distinguish the light emitting element without a contact failure and the light emitting element with a contact failure based on the measured light emission luminance. Accordingly, it is possible to appropriately detect the contact failure of the light emitting element and improve the accuracy of determination on whether the light emitting element is defective or not.

The inspection method may further include a second measurement step of irradiating the measurement object with light and measuring light emission generated in the measurement object in a state in which the conductive member does not contact the measurement object. The light emission luminance from the measurement object in a state in which the conductive member does not contact the measurement object varies depending on the presence or absence of the leak failure. Therefore, since the light emission from the measurement object irradiated with light is measured in a state in which the conductive member does not contact the measurement object, it is possible to distinguish the light emitting element without a leak failure and the light emitting element with a leak failure based on the measured light emission luminance. Accordingly, it is possible to appropriately detect the leak failure of the light emitting element.

The inspection method may further include a determination step of determining whether the light emitting element is defective or not based on an identification result obtained by identifying the light emitting element with a contact failure based on a measurement result in the first measurement step and identifying the light emitting element with a leak failure based on a measurement result in the second measurement step. According to such a configuration, it is possible to appropriately detect the light emitting element with a contact failure and the light emitting element with a leak failure as a defective product and improve the accuracy of determination on whether the light emitting element is defective or not.

In the contact step, the conductive member may be able to be attached to the measurement object. Accordingly, it is possible to perform the first measurement step in a state in which the conductive member stably contacts the measurement object.

The inspection method may further include an identification step of identifying a position corresponding to each light emitting element of the measurement object in a reflected image obtained by irradiating the measurement object with light and measuring reflected light from the measurement object based on the reflected image and previously acquired design data of the measurement object. Accordingly, it is possible to determine a certain light emitting element that generates light emission on the design data when measuring the light emission.

A conductive member according to an aspect of the present invention is a conductive member that is used in the inspection method and is able to contact the measurement object. According to such a conductive member, the inspection method is appropriately performed, the contact failure of the light emitting element is appropriately detected, and the accuracy of determination on whether the light emitting element is defective or not can be improved.

The conductive member may be able to be attached to the measurement object. Since such a conductive member is able to stably contact the measurement object, the inspection related to the contact failure can be more appropriately performed.

An inspection apparatus according to an aspect of the present invention includes: a light irradiation part irradiating a measurement object provided with a plurality of light emitting elements with light; an optical measurement part measuring light emission generated in the measurement object in response to the light irradiated by the light irradiation part; and a process unit outputting a measurement result of the optical measurement part, wherein the process unit outputs a measurement result of the optical measurement part in a state in which a conductive member contacts the measurement object. As described above, the light emission luminance from the measurement object in a state in which the conductive member contacts the measurement object varies depending on the presence or absence of the contact failure. Therefore, as in the inspection apparatus according to an aspect of the present invention, since the measurement result of the optical measurement part is output in a state in which the conductive member contacts the measurement object, it is possible to distinguish the light emitting element without a contact failure and the light emitting element with a contact failure based on the measured light emission luminance. Accordingly, it is possible to appropriately detect the contact failure of the light emitting element and improve the accuracy of determination on whether the light emitting element is defective or not.

The process unit may further output a measurement result of the optical measurement part in a state in which the conductive member does not contact the measurement object. As described above, the light emission luminance from the measurement object in a state in which the conductive member does not contact the measurement object varies depending on the presence or absence of the leak failure. Therefore, since the measurement result of the optical measurement part is output in a state in which the conductive member does not contact the measurement object, it is possible to distinguish the light emitting element without a leak failure and the light emitting element with a leak failure based on the measured light emission luminance. Accordingly, it is possible to appropriately detect the leak failure of the light emitting element.

The process unit may determine whether the light emitting element is defective or not based on an identification result obtained by identifying the light emitting element with a contact failure from a measurement result of the optical measurement part in a state in which the conductive member contacts the measurement object and identifying the light emitting element with a leak failure from a measurement result of the optical measurement part in a state in which the conductive member does not contact the measurement object. According to such a configuration, it is possible to appropriately detect the light emitting element with a contact failure and the light emitting element with a leak failure as a defective product and improve the accuracy of determination on whether the light emitting element is defective or not.

In the inspection apparatus, the conductive member may be attached to the measurement object in a state in which the conductive member contacts the measurement object. Accordingly, it is possible to perform an inspection related to a contact failure in a state in which the conductive member stably contacts the measurement object.

The optical measurement part may further measure reflected light from the measurement object in response to the light irradiated by the light irradiation part, and the process unit may identify a position corresponding to each light emitting element of the measurement object in a reflected image, obtained by measuring the reflected light in the optical measurement part, based on the reflected image and previously acquired design data of the measurement object. Accordingly, it is possible to determine a certain light emitting element that generates light emission on the design data when measuring the light emission.

### Advantageous Effects of Invention

According to an aspect of the present invention, it is possible to appropriately detect the contact failure of the light emitting element and improve the accuracy of determination on whether the light emitting element is defective or not.

### Brief Description of Drawings

FIG. 1 is a configuration diagram of an inspection apparatus according to an embodiment of the present invention.
FIG. 2 is a diagram showing a short circuit failure and a contact failure of a PL image.
FIG. 3 is a flowchart showing a sequence of an inspection method.

### Description of Embodiments

Hereinafter, an embodiment of the present invention will be described in detail with reference to the drawings. In each figure, the same or corresponding parts are denoted by the same reference numerals, and redundant descriptions are omitted.

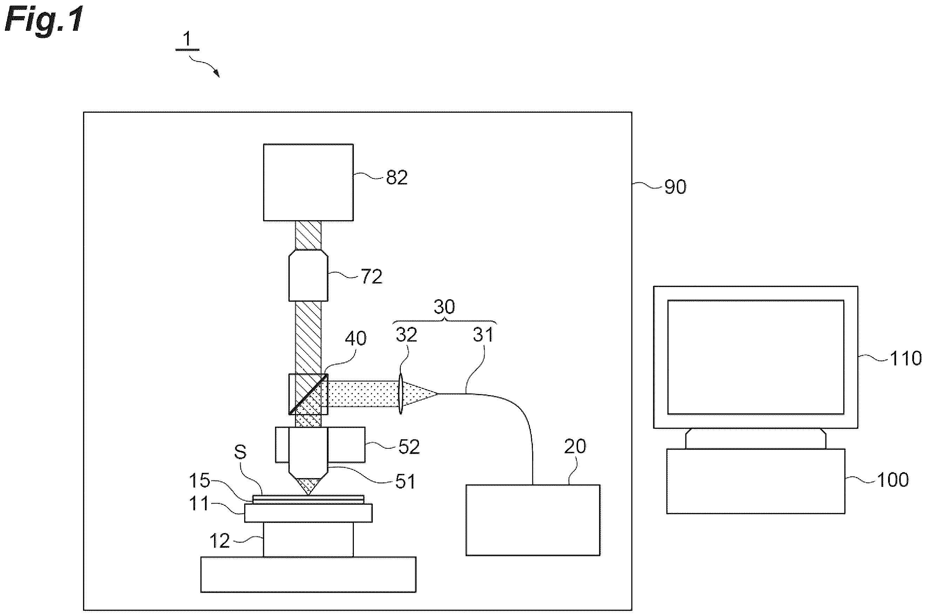

FIG. 1 is a configuration diagram of an inspection apparatus 1 according to this embodiment. The inspection apparatus 1 is an apparatus which inspects a sample S (measurement object). The sample S is, for example, a semiconductor device in which a plurality of light emitting elements are formed on a wafer. The light emitting element is, for example, an LED, a mini-LED, a µLED, an SLD element, a laser element, a vertical laser element (VCSEL), or the like. The inspection apparatus 1 determines whether a product is a defective product corresponding to a contact failure or a leak failure or whether the product is a non-defective product by observing photoluminescence (specifically, fluorescence) for each of the plurality of light emitting elements formed on the sample S. Additionally, it is also conceivable to inspect such a light emitting element, for example, by probing (that is, based on electrical characteristics). However, for fine LEDs such as µLEDs, it is physically difficult to probe with a needle for measurement. In this regard, since the method of inspecting the light emitting element based on photoluminescence according to this embodiment can perform inspection by acquiring a fluorescence image, a large number of light emitting elements can be efficiently inspected without being bound by physical restrictions.

As shown in FIG. 1, the inspection apparatus 1 includes a chuck 11, an XY stage 12, an excitation light source 20 (light irradiation part), an optical system 30, a dichroic mirror 40, an objective lens 51, a Z stage 52, an imaging lens 72, a camera 82 (optical measurement part), a dark box 90, a control apparatus 100 (process unit), and a monitor 110. The dark box 90 accommodates, for example, a component other than the control apparatus 100 and the monitor 110 in the above-described components and is provided to avoid the influence of external light on each accommodated component. Additionally, each component accommodated in the dark box 90 may be mounted on an anti-vibration table in order to improve the quality of the image captured by the camera 82 (improvement of image quality and prevention of positional deviation of the image).

The chuck 11 is a holding member that holds the sample S. For example, the chuck 11 holds the sample S by vacuum-sucking the wafer of the sample S. The XY stage 12 is a stage that moves the chuck 11 holding the sample S in the XY direction (the front and rear direction and the left and right direction), that is, the direction along the placement surface of the sample S in the chuck 11. The XY stage 12 moves the chuck 11 in the XY direction so that each of the plurality of light emitting elements is sequentially irradiated with the excitation light in the irradiation region in response to the control of the control apparatus 100. Additionally, the inspection apparatus 1 may further include a rotation stage (Θ stage not shown). Such a rotation stage may be provided, for example, above the XY stage 12 and below the chuck 11 or may be provided integrally with the XY stage 12. The rotation stage is for accurately aligning the vertical and horizontal positions of the sample S. Since the rotation stage is provided, it is possible to shorten the time for alignment and the like and shorten the total time for data processing.

The excitation light source 20 is a light irradiation part which generates excitation light to irradiate the sample S and irradiates the sample S with the excitation light. The excitation light source 20 may be a light source capable of generating light having a wavelength that excites the light emitting element of the sample S, such as an LED, a laser, a halogen lamp, a mercury lamp, a D2 lamp, and a plasma light source. In addition, the inspection apparatus 1 may further include a sensor for monitoring the illumination luminance in order to keep the luminance of the excitation light emitted from the excitation light source 20 constant. Further, in order to reduce shading as much as possible, a diffusion plate, a fly-eye lens, or the like may be used at the position where the excitation light is emitted from the excitation light source 20 to homogenize the luminance distribution.

The optical system 30 includes an optical fiber cable 31 and a light guide lens 32. The optical fiber cable 31 is a light guiding optical fiber cable connected to the excitation light source 20. As the optical fiber cable 31, for example, a polarization maintaining fiber, a single mode fiber, or the like can be used. The light guide lens 32 is, for example, a single or compound convex lens, and guides the excitation light reaching via the optical fiber cable 31 toward the dichroic mirror 40. In order to prevent the wavelength of the excitation light emitted from the excitation light source 20 from changing with time, the inspection apparatus 1 may include a bandpass filter (not shown) between the excitation light source 20 and the dichroic mirror 40.

The dichroic mirror 40 is a mirror made of a special optical material that reflects light of a specific wavelength and transmits light of other wavelengths. Specifically, the dichroic mirror 40 is configured to reflect the excitation light in the direction of the objective lens 51 and to transmit photoluminescence (more specifically, fluorescence) from the light emitting element, which is light in a wavelength band different from that of the excitation light, in the direction of the imaging lens 72. In addition, the region of the normal emission spectrum of excitation light may be on the lower wavelength side than the region of the normal emission spectrum of fluorescence (normal fluorescence spectrum). That is, the dichroic mirror 40 reflects the excitation light which is light in a low wavelength band toward the objective lens 51 and transmits fluorescence which is light in a higher wavelength band than the excitation light toward the imaging lens 72.

The objective lens 51 is configured to observe the sample S and collects the excitation light guided by the dichroic mirror 40 onto the sample S. The Z stage 52 moves the objective lens 51 in the Z direction (up and down direction), that is, in a direction intersecting the placement surface of the sample S in the chuck 11 to perform focus adjustment.

The imaging lens 72 is a lens which forms an image of the fluorescence of the light emitting element having passed through the dichroic mirror 40 and guides the fluorescence to the camera 82. The camera 82 captures the fluorescence of the light emitting element. That is, the camera 82 measures by capturing the luminescence (fluorescence) generated in the sample S in response to the excitation light emitted by the excitation light source 20. The camera 82 detects the image formed by the imaging lens 72. The camera 82 outputs a PL image (fluorescence image), which is the imaging result, to the control apparatus 100. The camera 82 is, for example, an area image sensor such as CCD or MOS. Further, the camera 82 may be configured by a line sensor or a TDI sensor. Additionally, the camera 82 also captures (measures) reflected light from the sample S in response to the excitation light irradiating the sample S by the excitation light source 20 as will be described later.

The control apparatus 100 controls the XY stage 12, the excitation light source 20, the Z stage 52, and the camera 82. Specifically, the control apparatus 100 adjusts the irradiation region of the excitation light (the irradiation region in the sample S) by controlling the XY stage 12. The control apparatus 100 performs focus adjustment related to the excitation light by controlling the Z stage 52. The control apparatus 100 adjusts the emission of the excitation light and adjusts the wavelength and amplitude of the excitation light by controlling the excitation light source 20. The control apparatus 100 controls the camera 82 to perform adjustment related to the acquisition of fluorescence image. Further, the control apparatus 100 determines whether the light emitting element is defective or not based on the fluorescence image captured by the camera 82 (details will be described later). Additionally, the control apparatus 100 is a computer, and physically includes a memory such as a RAM and a ROM, a processor (arithmetic circuit) such as a CPU, a communication interface, and a storage unit such as a hard disk. Examples of the control apparatus 100 include personal computers, cloud servers, and smart devices (smartphones, tablet terminals, and the like). The control apparatus 100 functions by executing a program stored in a memory by the CPU of the computer system. The monitor 110 is a display apparatus that displays a PL image (fluorescence image) or the like, which is a measurement result.

Next, the details of an inspection method of determining whether the light emitting element is defective or not will be described.

This inspection method includes a contact step, a first measurement step, a second measurement step, a determination step, and an identification step. The first measurement step (and the contact step performed before the first measurement step) may be performed before the second measurement step or after the second measurement step. The determination step is performed after the first measurement step and the second measurement step. The identification step is performed before the first measurement step (and the contact step performed before the first measurement step) and before the second measurement step.

The contact step is a step of bringing a sheet-like conductive tape 15 which is a conductive member into contact with the sample S provided with a plurality of light emitting elements. The conductive tape 15 is formed to be able to contact the sample S. More specifically, the conductive tape 15 is able to be attached to the sample S. In the contact step, the conductive tape 15 is attached to the sample S. That is, the conductive tape 15 is attached to the sample S in a state in which the conductive tape 15 contacts the sample S.

The conductive tape 15 is attached to, for example, a device surface which is a surface provided with the light emitting element in the sample S. The conductive tape 15 may be attached to at least a part of the device surface instead of the entire device surface. The conductive tape 15 may be, for example, a conductive dicing tape that is an adhesive tape for fixing the sample S in the dicing process of the sample S, which is a post-process, and has conductivity. As shown in FIG. 1, the sample S is disposed so that the device surface to which the conductive tape 15 is attached is the surface to be sucked by the chuck 11 and the rear surface which is the opposite surface is the excitation light irradiation surface after the contact step. Additionally, when the conductive tape 15 is sucked by the chuck 11, the conductive tape 15 may peel off from the sample S. Therefore, the suction area of the chuck 11 may be an area of the device surface of the sample S to which the conductive tape 15 is not attached. That is, for example, when the conductive tape 15 is the center portion of the device surface of the sample S, the peripheral portion of the device surface (an area in which the conductive tape 15 is not attached) may be the suction area. In this embodiment, although the conductive member is described as the conductive tape 15, the conductive member may be a sheet-like member other than a tape (a member that simply contacts the sample S without being attached) or may be a non-sheet-like member. Further, when the chuck 11 itself has conductivity, the chuck 11 may function as a conductive member. Further, a conductive layer that functions as a conductive member may be formed on the surface of the sample S in advance.

The first measurement step is a step of irradiating the sample S with the excitation light and measuring the light emission generated in the sample S in a state in which the conductive tape 15 contacts the sample S after the contact step. The first measurement step is a measurement step related to the detection of the light emitting element with a contact failure (details will be described later). In the first measurement step, as shown in FIG. 1, the rear surface of the sample S is irradiated with the excitation light emitted from the excitation light source 20 in a state in which the sample S is disposed on the chuck 11. Then, the light emission generated in the sample S in response to the excitation light is transmitted through the dichroic mirror 40, imaged by the imaging lens 72, and detected (measured) as a PL image in the camera 82. Then, the control apparatus 100 outputs a detection (measurement) result of the camera 82 in a state in which the conductive tape 15 contacts the sample S for the determination step to be described later.

The second measurement step is a step of irradiating the sample S with the excitation light and measuring the light emission generated in the sample S in a state in which the conductive tape 15 does not contact the sample S. The second measurement step is a measurement step related to the detection of the light emitting element with a leak failure (details will be described later). In the second measurement step, for example, in a state in which the sample S is disposed on the chuck 11, the device surface of the sample S is irradiated with the excitation light emitted from the excitation light source 20. In this way, the rear surface of the sample S is the irradiation surface in the first measurement step, but the device surface of the sample S is the irradiation surface in the second measurement step. Then, the light emission generated in the sample S in response to the excitation light is transmitted through the dichroic mirror 40, imaged by the imaging lens 72, and detected (measured) as the PL image in the camera 82. Then, the control apparatus 100 outputs the detection (measurement) result of the camera 82 in a state in which the conductive tape 15 does not contact the sample S for the determination step to be described later.

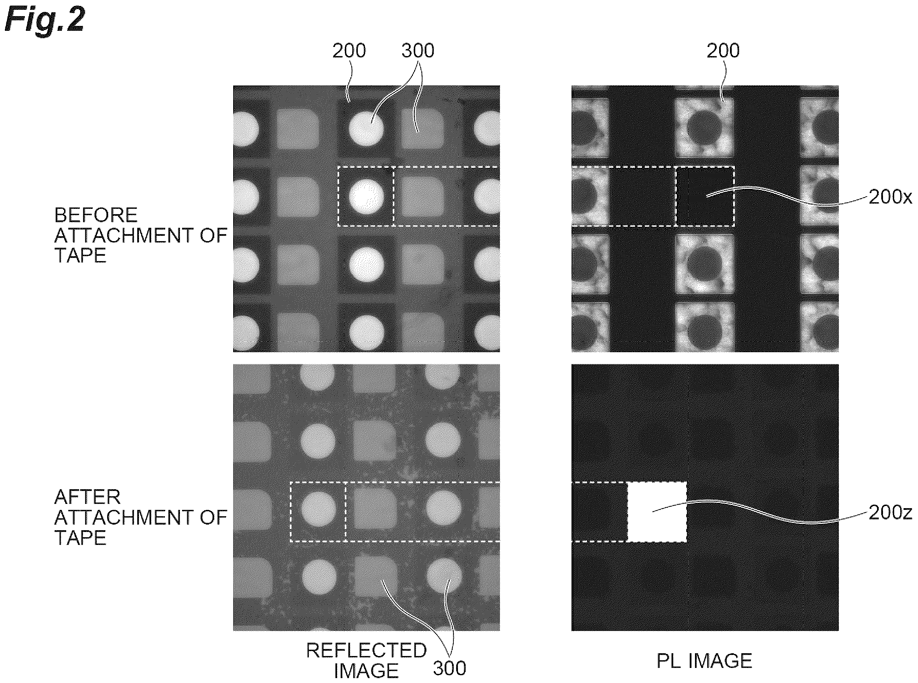

The identification step is performed before the first measurement step and the second measurement step and is a step of aligning the light emitting elements. In the identification step, a position corresponding to each light emitting element of the sample S in the reflected image is identified based on the previously acquired design data of the sample S and the reflected image obtained by irradiating the sample S with light and measuring the reflected light from the sample S (the light emitting elements are aligned). In the identification step before the first measurement step, the rear surface of the sample S is irradiated with the light emitted from the excitation light source 20 and the reflected light is detected by the camera 82 to acquire a reflected image (see the lower left diagram of FIG. 2). In the identification step before the second measurement step, the device surface of the sample S is irradiated with the light emitted from the excitation light source 20 and the reflected light is detected by the camera 82 to acquire a reflected image (see the upper left diagram of FIG. 2). As shown in the lower left and upper left diagrams of FIG. 2, the reflected image shows an image corresponding to each light emitting element 200 and each electrode 300. Then, for example, the control apparatus 100 identifies the position corresponding to each light emitting element of the sample S in the reflected image by comparing the reflected image with the design data of the sample S. The design data here indicates at least the state (position, shape, and the like) of each light emitting element and electrode of the sample S. In this way, since each light emitting element of the sample S identifies a certain position of the acquired image before the first measurement step and the second measurement step, it is possible to identify a certain light emitting element corresponding to each position of the PL image acquired in the first measurement step and the second measurement step. Additionally, since the identification step before the first measurement step and the identification step before the second measurement step are different in the observation surface of the reflected image as described above, it is necessary to match (convert) addresses between the two reflected images when identifying each position of the PL image corresponding to a certain light emitting element.

The determination step is performed by the control apparatus 100. In the determination step, the control apparatus 100 identifies the light emitting element with a contact failure based on the measurement result of the first measurement step (the measurement result of the camera 82 in a state in which the conductive tape 15 contacts the sample S), identifies the light emitting element with a leak failure based on the measurement result of the second measurement step (the measurement result of the camera 82 in a state in which the conductive tape 15 does not contact the sample S), and determines whether the light emitting element is a non-defective product or a defective product based on the identification result.

The identification of the contact failure will be described. A state in which the conductive tape 15 contacts the sample S corresponding to a state in which the first measurement step is performed is a state in which each light emitting element is in a short-circuited state. Therefore, recombination of carriers is less likely to occur in a non-defective light emitting element, and the light emission luminance is relatively low. On the other hand, since recombination of carriers actively occurs in the light emitting element with a contact failure even in a state in which the conductive tape 15 contacts the sample S (in a short-circuited state of each light emitting element), the light emission luminance is higher than that of the non-defective light emitting element. In this way, the light emission luminance related to each light emitting element measured in the first measurement step varies depending on the presence or absence of the contact failure. The control apparatus 100 identifies the luminance of each the light emitting element in the PL image and identifies the light emitting element with a contact failure based on the luminance. In the lower right PL image of FIG. 2, only the luminance of a certain light emitting element 200z is higher than those of the other light emitting elements. In such a case, the control apparatus 100 identifies the light emitting element 200z as the light emitting element with a contact failure. The control apparatus 100 generates and outputs a contact failure map defining the address of the light emitting element with a contact failure.

The identification of the leak failure will be described. Regarding the light emission from the light emitting element in a state in which the conductive tape 15 does not contact the sample S corresponding to a state in which the second measurement step is performed, the light emission luminance of the light emitting element with a leak failure (short circuit failure) is extremely lower than that of the non-defective light emitting element. The control apparatus 100 identifies the luminance of each light emitting element in the PL image and identifies the light emitting element with a leak failure based on the luminance. In the upper right PL image of FIG. 2, only the luminance of a certain light emitting element 200x is extremely lower than those of the other light emitting elements. In such a case, the control apparatus 100 identifies the light emitting element 200x as the light emitting element with a leak failure. The control apparatus 100 generates and outputs a leak failure map defining the address of the light emitting element with a leak failure.

Then, the control apparatus 100 identifies the non-defective light emitting element based on the contact failure map and the leak failure map and outputs the address of the non-defective light emitting element. That is, the control apparatus 100 derives the exclusive OR of the contact failure map and the leak failure map to identify the light emitting elements without contact failures and leak failures, determines the light emitting elements as non-defective products, determines the other light emitting elements as defective products, and outputs the addresses of the non-defective light emitting elements. Accordingly, it is possible to improve the quality of panels and the like using light emitting elements without using the defective light emitting element in subsequent processes. Further, it is possible to prepare a wafer from which defective light emitting elements are removed by laser lift-off or the like in advance based on the contact failure map and the leak failure map. Additionally, the control apparatus 100 may distinguish the non-defective light emitting element and the defective light emitting element and output each address. Further, the control apparatus 100 may distinguish the light emitting element with a contact failure and the light emitting element with a leak failure and output each address.

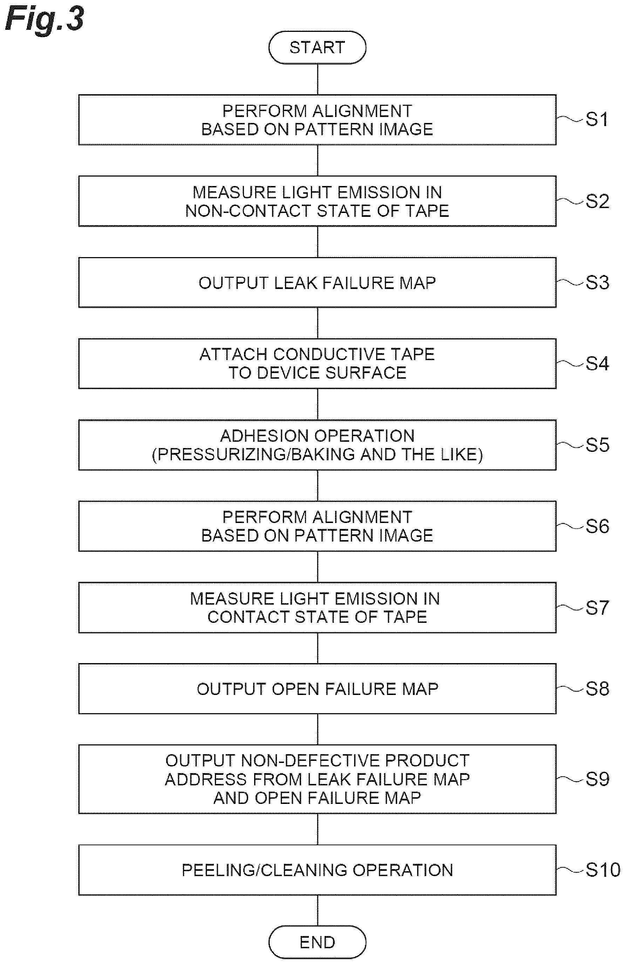

Next, a sequence of the inspection method will be described with reference to FIG. 3. FIG. 3 is a flowchart showing a sequence of the inspection method. Additionally, the sequence shown in FIG. 3 is an example and, for example, a process group (a process group related to the detection of the contact failure) of step S4 to step S8 may performed earlier than a process group (a process group related to the detection of the leak failure) of step S1 to step S3. However, in that case, a peeling/cleaning operation (details will be described later) in step S10 needs to be performed before the process group related to the detection of the leak failure starts after the process group related to the detection of the contact failure ends.

As shown in FIG. 3, as a first process of the process group (step S1 to step S3) related to the detection of the leak failure, a process of aligning the light emitting elements based on a pattern image (reflected image) is performed (step S1: identification step). Specifically, a position corresponding to each light emitting element of the sample S in the reflected image is identified based on the previously acquired design data of the sample S and the reflected image obtained by irradiating the sample S with light and measuring the reflected light from the sample S.

Next, in a non-contact state in which the conductive tape 15 does not contact the sample S, the sample S is irradiated with the excitation light and the light emission generated in the sample S is measured (step S2: second measurement step). In the second measurement step, for example, in a state in which the sample S is disposed on the chuck 11, the device surface of the sample S is irradiated with the excitation light emitted from the excitation light source 20.

Next, the luminance of each light emitting element in the PL image obtained in step S2 is identified, the light emitting element with a leak failure is identified based on the luminance, and a leak failure map defining the address of the light emitting element with a leak failure is generated and output (step S3: determination step). In step S3, the control apparatus 100 identifies the light emitting element having luminance extremely lower than those of the other light emitting elements as the light emitting element with a leak failure.

Next, as a first process of the process group (step S4 to step S8) related to the detection of the contact failure, a process of bonding (attaching) the conductive tape 15 to the device surface of the sample S is performed (step S4: contact step). A bonding operation may be performed in an atmospheric pressure state or a vacuum state. In the latter case, for example, the sample S may be placed in a chamber and the conductive tape 15 may be bonded to the device surface in a vacuum state. Next, a conductive tape adhesion operation (a process such as pressurizing/baking) is performed (step S5).

Next, a process of aligning the light emitting elements based on the pattern image (reflected image) is performed (step S6: identification step). Specifically, a position corresponding to each light emitting element of the sample S in the reflected image is identified based on the previously acquired design data of the sample S and the reflected image obtained by irradiating the sample S with light and measuring the reflected light from the sample S.

Next, the sample S is irradiated with the excitation light in a non-contact state in which the conductive tape 15 contacts the sample S and the light emission generated in the sample S is measured (step S7: first measurement step). In the first measurement step, for example, in a state in which the sample S is disposed on the chuck 11, the rear surface of the sample S is irradiated with the excitation light emitted from the excitation light source 20.

Next, the luminance of each light emitting element in the PL image obtained in step S7 is identified, the light emitting element with a contact failure is identified based on the luminance, and the contact failure map defining the address of the light emitting element with a contact failure is generated and output (step S8: determination step). In step S8, the control apparatus 100 identifies the light emitting element having luminance higher than those of the other light emitting elements as the light emitting element with a leak failure.

Next, the non-defective light emitting element is identified based on the contact failure map and the leak failure map and the address of the non-defective light emitting element is output (step S9: determination step).

Finally, a peeling/cleaning operation is performed (step S10). The peeling operation is an operation of peeling the conductive tape 15 from the device surface of the sample S. The peeling method differs depending on the bonding method of the conductive tape 15. For example, the peeling method such as irradiating the conductive tape 15 with UV may be adopted. The cleaning operation is an operation of cleaning the bonding surface of the sample S after peeling. As the cleaning method, for example, organic cleaning such as acetone and alkali cleaning for dissolving and removing organic matter may be adopted. Further, when the electrode material of the light emitting element such as LED is, for example, a conductive oxide of ITO or the like, cleaning with acid or removal of organic matter with O₂ plasma is effective.

Although the embodiments and modified examples of the present invention have been described above, the present invention is not necessarily limited to the above-described embodiments and modified examples, and various modifications can be made without departing from the scope of the invention.

For example, the conductive member may be a conductive film formed by depositing a liquid conductive material on the device surface of the sample S. The conductive film may be formed by, for example, spin coating after placing the sample S on a spin coater. Alternatively, the conductive film may be formed spray coating after placing the sample S on a spray coater. For example, a water soluble organic film may be used as the conductive film. In this case, the removal can be easily performed by cleaning with water in the peeling operation.

Next, the operation and effect of the inspection method, the conductive tape 15, and the inspection apparatus 1 according to this embodiment will be described.

The inspection method according to this embodiment includes a contact step of bringing the conductive tape 15 into contact with the sample S provided with a plurality of light emitting elements and a first measurement step of irradiating the sample S with light and measuring the light emission generated in the sample S in a state in which the conductive tape 15 contacts the sample S after the contact step.

According to the inspection method of this embodiment, the sample S is irradiated with light and the light emission from the sample S is measured in a state in which the conductive tape 15 contacts the sample S provided with a plurality of light emitting elements. Here, since a state in which the conductive tape 15 contacts the sample S is a state in which each light emitting element is in a short-circuited state, recombination of carriers is less likely to occur in the non-defective light emitting element and the light emission luminance is low. On the other hand, since recombination of carriers actively occurs in the light emitting element with a contact failure even in a state in which the conductive tape 15 contacts the sample S (in a short-circuited state of each light emitting element), the light emission luminance is higher than that of the non-defective light emitting element. In this way, the light emission luminance from the sample S in a state in which the conductive tape 15 contacts the sample S varies depending on the presence or absence of the contact failure. Therefore, as in the inspection method according to this embodiment, since the sample S is irradiated with light and the light emission from the sample S is measured in a state in which the conductive tape 15 contacts the sample S, it is possible to distinguish the light emitting element without a contact failure and the light emitting element with a contact failure based on the measured light emission luminance. Accordingly, it is possible to appropriately detect the contact failure of the light emitting element and improve the accuracy of determination on whether the light emitting element is defective or not.

The inspection method may further include a second measurement step of irradiating the sample S with light and measuring the light emission generated in the sample S in a state in which the conductive tape 15 does not contact the sample S. The light emission luminance from the sample S in a state in which the conductive tape 15 does not contact the sample S varies depending on the presence or absence of the leak failure. Therefore, since the light emission from the sample S irradiated with light is measured in a state in which the conductive tape 15 does not contact the sample S, it is possible to distinguish the light emitting element without a leak failure and the light emitting element with a leak failure based on the measured light emission luminance. Accordingly, it is possible to appropriately detect the leak failure of the light emitting element.

The inspection method may further include a determination step of identifying the light emitting element with a contact failure based on the measurement result in the first measurement step, identifying the light emitting element with a leak failure based on the measurement result in the second measurement step, and determining whether the light emitting element is defective or not based on the identification result. According to such a configuration, it is possible to appropriately detect the light emitting element with a contact failure and the light emitting element with a leak failure as a defective product and improve the accuracy of determination on whether the light emitting element is defective or not.

In the contact step, the conductive tape 15 may be attached to the sample S. Accordingly, it is possible to perform the first measurement step in a state in which the conductive tape 15 stably contacts the sample S.

The inspection method may further include an identification step of identifying a position corresponding to each light emitting element of the sample S in the reflected image based on the previously acquired design data of the sample S and the reflected image obtained by irradiating the sample S with light and measuring the reflected light from the sample S. Accordingly, it is possible to determine a certain light emitting element that generates light emission on the design data when measuring the light emission.

The conductive tape 15 according to this embodiment is a conductive member that is used in the inspection method and is able to contact the sample S. According to such a conductive tape 15, the inspection method is appropriately performed, the contact failure of the light emitting element is appropriately detected, and the accuracy of determination on whether the light emitting element is defective or not can be improved.

The conductive tape 15 may be attached to the sample S. Since such a conductive tape 15 is able to stably contact the sample S, the inspection related to the contact failure can be more appropriately performed.

The inspection apparatus 1 according to this embodiment includes the excitation light source 20 which irradiates the sample S provided with a plurality of light emitting elements with light, the camera 82 which measures the light emission generated in the sample S in response to the light irradiated by the excitation light source 20, and the control apparatus 100 which outputs the measurement result of the camera 82 and the control apparatus 100 outputs the measurement result of the camera 82 in a state in which the conductive tape 15 contacts the sample S. As described above, the light emission luminance from the sample S in a state in which the conductive tape 15 contacts the sample S varies depending on the presence or absence of the contact failure. Therefore, as in the inspection apparatus 1 according to this embodiment, since the measurement result of the camera 82 in a state in which the conductive tape 15 contacts the sample S is output, it is possible to distinguish the light emitting element without a contact failure and the light emitting element with a contact failure based on the measured light emission luminance. Accordingly, it is possible to appropriately detect the contact failure of the light emitting element and improve the accuracy of determination on whether the light emitting element is defective or not.

The control apparatus 100 may further output the measurement result of the camera 82 in a state in which the conductive tape 15 does not contact the sample S. As described above, the light emission luminance from the sample S in a state in which the conductive tape 15 does not contact the sample S varies depending on the presence or absence of the leak failure. Therefore, since the measurement result of the camera 82 is output in a state in which the conductive tape 15 does not contact the sample S, it is possible to distinguish the light emitting element with a leak failure and the light emitting element with a leak failure based on the measured light emission luminance. Accordingly, it is possible to appropriately detect the leak failure of the light emitting element.

The control apparatus 100 may identify the light emitting element with a contact failure from the measurement result of the camera 82 in which the conductive tape 15 contacts the sample S, identify the light emitting element with a leak failure from the measurement result of the camera 82 in a state in which the conductive tape 15 does not contact the sample S, and determine whether the light emitting element is defective or not based on the identification result. According to such a configuration, it is possible to appropriately detect the light emitting element with a contact failure and the light emitting element with a leak failure as a defective product and improve the accuracy of determination on whether the light emitting element is defective or not.

In the inspection apparatus 1, the conductive tape 15 may be attached to the sample S in a state in which the conductive tape 15 contacts the sample S. Accordingly, it is possible to perform an inspection related to a contact failure in a state in which the conductive tape 15 stably contacts the sample S.

The camera 82 may further measure the reflected light from the sample S in response to the light irradiated by the excitation light source 20 and the control apparatus 100 may identify a position corresponding to each light emitting element of the sample S in the reflected image based on the previously acquired design data of the sample S and the reflected image obtained by measuring the reflected light in the camera 82. Accordingly, it is possible to determine a certain light emitting element that generates light emission on the design data when measuring the light emission.

### Reference Signs List

1 Inspection apparatus
15 Conductive tape (conductive member)
20 Excitation light source (light irradiation part)
82 Camera (optical measurement part)
100 Control apparatus (process unit)

## Claims

1. An inspection method comprising:
a contact step of bringing a conductive member into contact with a measurement object provided with a plurality of light emitting elements; and
a first measurement step of irradiating the measurement object with light and measuring light emission generated in the measurement object in a state in which the conductive member contacts the measurement object after the contact step.

2. The inspection method according to claim 1, further comprising:
a second measurement step of irradiating the measurement object with light and measuring light emission generated in the measurement object in a state in which the conductive member does not contact the measurement object.

3. The inspection method according to claim 2, further comprising:
a determination step of determining whether the light emitting element is defective or not based on an identification result obtained by identifying the light emitting element with a contact failure based on a measurement result in the first measurement step and identifying the light emitting element with a leak failure based on a measurement result in the second measurement step.

4. The inspection method according to any one of claims 1 to 3,
wherein in the contact step, the conductive member is attached to the measurement object.

5. The inspection method according to any one of claims 1 to 4, further comprising:
an identification step of identifying a position corresponding to each light emitting element of the measurement object in a reflected image obtained by irradiating the measurement object with light and measuring reflected light from the measurement object based on the reflected image and previously acquired design data of the measurement object.

6. A conductive member used in the inspection method according to any one of claims 1 to 5,
wherein the conductive member is able to contact the measurement object.

7. The conductive member according to claim 6,
wherein the conductive member is able to be attached to the measurement object.

8. An inspection apparatus comprising:
a light irradiation part irradiating a measurement object provided with a plurality of light emitting elements with light;
an optical measurement part measuring light emission generated in the measurement object in response to the light irradiated by the light irradiation part; and
a process unit outputting a measurement result of the optical measurement part,
wherein the process unit outputs a measurement result of the optical measurement part in a state in which a conductive member contacts the measurement object.

9. The inspection apparatus according to claim 8,
wherein the process unit further outputs a measurement result of the optical measurement part in a state in which the conductive member does not contact the measurement object.

10. The inspection apparatus according to claim 9,
wherein the process unit determines whether the light emitting element is defective or not based on an identification result obtained by identifying the light emitting element with a contact failure from a measurement result of the optical measurement part in a state in which the conductive member contacts the measurement object and identifying the light emitting element with a leak failure from a measurement result of the optical measurement part in a state in which the conductive member does not contact the measurement object.

11. The inspection apparatus according to any one of claims 8 to 10,
wherein the conductive member is attached to the measurement object in a state in which the conductive member contacts the measurement object.

12. The inspection apparatus according to any one of claims 8 to 11,
wherein the optical measurement part further measures reflected light from the measurement object in response to the light irradiated by the light irradiation part, and
wherein the process unit identifies a position corresponding to each light emitting element of the measurement object in a reflected image, obtained by measuring the reflected light in the optical measurement part, based on the reflected image and previously acquired design data of the measurement object.
